# EUROPEAN PATENT APPLICATION

(11) **EP 4 730 079 A1**
(43) Date of publication of application: **22.04.2026**
(21) Application number: 24854034.6
(22) Date of filing: 05.02.2024
(51) Int. Cl.: G06F 1/20, H05K 7/20

(54) **CONTAINER-TYPE DATA CENTER AND CONTROL METHOD THEREFOR**

(30) Priority: 17.08.2023 JP 2023132922
(71) Applicant: Mitsubishi Heavy Industries, Ltd., Tokyo 100-8332 (JP)
(72) Inventor: INOUE, Naoki, Tokyo 100-8332 (JP); KAJITANI, Fumito, Tokyo 100-8332 (JP); MATSUDA, Naohiko, Tokyo 100-8332 (JP)
(74) Representative: Studio Torta S.p.A.
(86) International application number: PCT/JP2024/003742
(87) International publication number: WO 2025/037440

(57) **Abstract**

Provided is a container-type data center capable of properly cooling an electronic apparatus to be cooled according to the amount of heat generated by the electronic apparatus. A container-type data center (1) comprises: a container body (2); a liquid immersion container (5) which is provided inside the container body (2), and in which is stored a cooling liquid into which an electronic apparatus is immersed and cooled; an air-cooling rack (6) that is provided inside the container body (2), and through which cooling air passes; and a water-cooling rack (7) that is provided inside the container body (2), and that is provided with a water-cooled heat sink installed in contact with a heat-generating part of the electronic apparatus.

## Description

### Technical Field

The present disclosure relates to a container-type data center accommodating an electronic device such as a server, and a control method therefor.

### Background Art

PTL 1 discloses a container-type data center that accommodates a server. In the container-type data center, a data center can be compactly constituted by accommodating a server in a standard container and providing a cooling device for cooling the server. In addition, since the container is excellent in portability, there is an advantage in that installation is easy.

### Citation List

### Patent Literature

[PTL 1] Japanese Patent No. 6293355

### Summary of Invention

### Technical Problem

In PTL 1, an air cooling method in which air is brought into contact with the server installed in a server rack to cool the server is adopted. However, depending on the amount of heat generated by the electronic device to be cooled, air cooling may be insufficient, and a water cooling method using a water-cooled heat sink or an immersion method in which the electronic device is immersed in a cooling liquid may be required.

The present disclosure has been made in view of such circumstances, and an object of the present disclosure is to provide a container-type data center and a control method therefor that can appropriately cool an electronic device in accordance with the amount of heat generated by the electronic device to be cooled.

### Solution to Problem

A container-type data center according to an aspect of the present disclosure includes a container body, an immersion vessel that is provided inside the container body and in which a cooling liquid for immersing and cooling an electronic device is stored, an air cooling rack that is provided inside the container body and through which cooling air passes, and a water cooling rack that is provided inside the container body and includes a water-cooled heat sink that is attached to a heat generating portion of the electronic device while being brought into contact with the heat generating portion.

A control method for a container-type data center according to an aspect of the present disclosure, the container-type data center including a container body, an immersion vessel that is provided inside the container body and in which a cooling liquid for immersing and cooling an electronic device is stored, an air cooling rack that is provided inside the container body and through which cooling air passes, a water cooling rack that is provided inside the container body and includes a water-cooled heat sink that is attached to a heat generating portion of the electronic device while being brought into contact with the heat generating portion, a vapor compression type cooling device including a compressor that compresses a refrigerant, an expansion valve that expands the compressed refrigerant, an air cooling evaporator that evaporates the expanded refrigerant and cools air, and a condenser that condenses the evaporated refrigerant, a cooling water type cooling device including a radiator that discharges sensible heat of cooling water to an outside of the container body to cool the cooling water, and an air cooling heat exchanger that cools air with the cooling water cooled by the radiator, and a cooling flow path in which the air cooling evaporator and the air cooling heat exchanger are disposed and through which cooling air guided to the air cooling rack flows, the control method further includes operating the air cooling heat exchanger to cool the cooling air guided to the air cooling rack in a case where a temperature outside the container body is equal to or lower than a predetermined value.

### Advantageous Effects of Invention

According to the present disclosure, an electronic device can be appropriately cooled in accordance with the amount of heat generated by the electronic device to be cooled.

### Brief Description of Drawings

FIG. 1 is a perspective view showing a front side of a container-type data center according to an embodiment of the present disclosure.
FIG. 2 is a perspective view showing a rear side of the container-type data center of FIG. 1.
FIG. 3 is a plan view of the container-type data center of FIG. 1.
FIG. 4 is a front view schematically showing a flow of cooling air flowing through an air cooling rack and a water cooling rack.
FIG. 5 is a schematic diagram showing a cooling circuit.
FIG. 6 is a perspective view showing a modification example.

### Description of Embodiments

An embodiment according to the present disclosure will be described below with reference to the drawings.

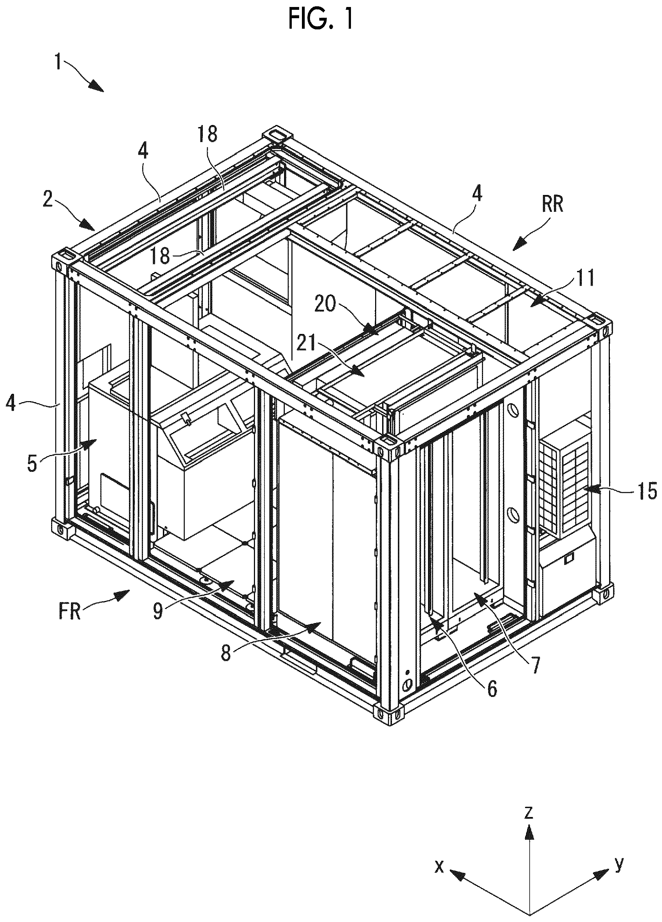

FIG. 1 shows a container-type data center 1. The container-type data center 1 has a standard container shape having portability. In FIG. 1, the container-type data center 1 is shown in a state where plate members forming the wall surfaces are removed so that an inside of the container-type data center 1 is visible.

The container-type data center 1 includes a container body 2 constituting an outer shape formed into, for example, a rectangular parallelepiped body. A width direction (longitudinal direction or x direction) of the container body 2 is, for example, equal to or less than 12 ft (3.66 m). A depth direction (y direction) of the container body 2 is less than a dimension in the width direction. Each side of the container body 2 formed into a rectangular parallelepiped body is constituted by frame members 4 formed, for example, as metal column members, and end portions of the respective frame members 4 are fixed to one another.

For example, when the container body 2 is viewed from a front surface FR side, an immersion vessel 5 for performing immersion cooling is provided on a left side, and an air cooling rack 6 and a water cooling rack 7 are provided on a right side. A distribution board 8 is provided on the front surface FR side of the air cooling rack 6. A central space when viewed from the front surface FR is a work space 9 in which a worker can enter.

The immersion vessel 5 is a bottomed vessel in which a cooling liquid is stored. As the cooling liquid, a liquid having electrical insulation is used, and, for example, silicone-based oil is used. The immersion vessel 5 is filled with the cooling liquid to a height at which a whole substrate installed in the immersion vessel 5 is immersed.

A plurality of substrates are installed in the immersion vessel 5. Each substrate, for example, is a substrate that constitutes a server, and is arranged at a predetermined interval in a state in which the longitudinal direction is directed to a vertical direction. A plurality of electronic components such as a CPU, a power supply unit, a memory, a storage such as a hard disk or a solid-state drive (SSD), and a communication unit for configuring a server are mounted on the substrate. These electronic components generate heat during the operation of the server and are cooled by the cooling liquid.

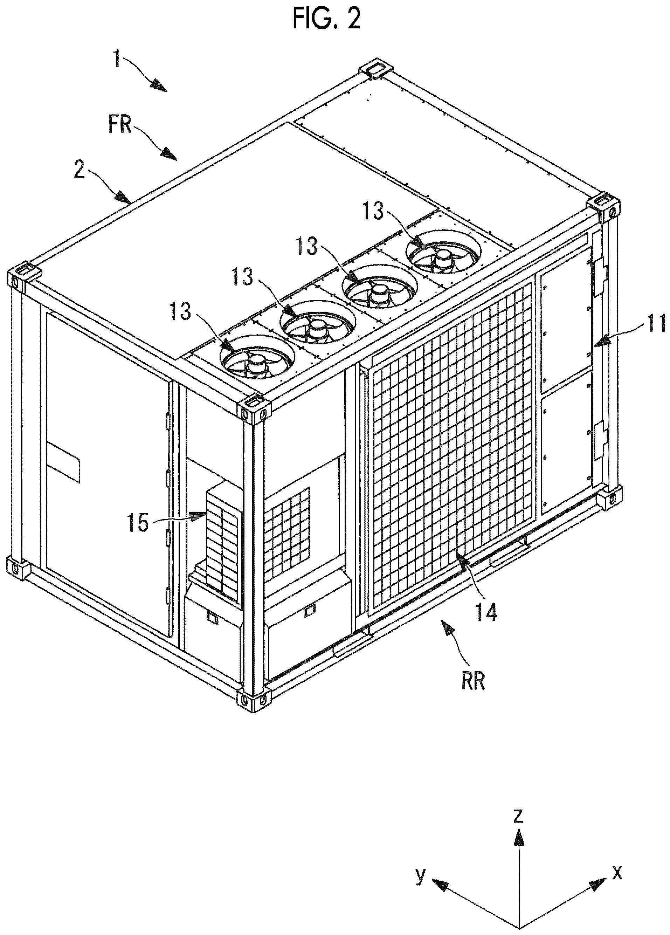

A machine room 11 is provided on a rear surface RR side of the container body 2. As shown in FIG. 2, for example, four air cooling fans 13 on a ceiling, a radiator 14, and an outdoor unit 15 are provided in the machine room 11. The number of the air cooling fans 13 is not limited to four and may be changed as needed and as appropriate.

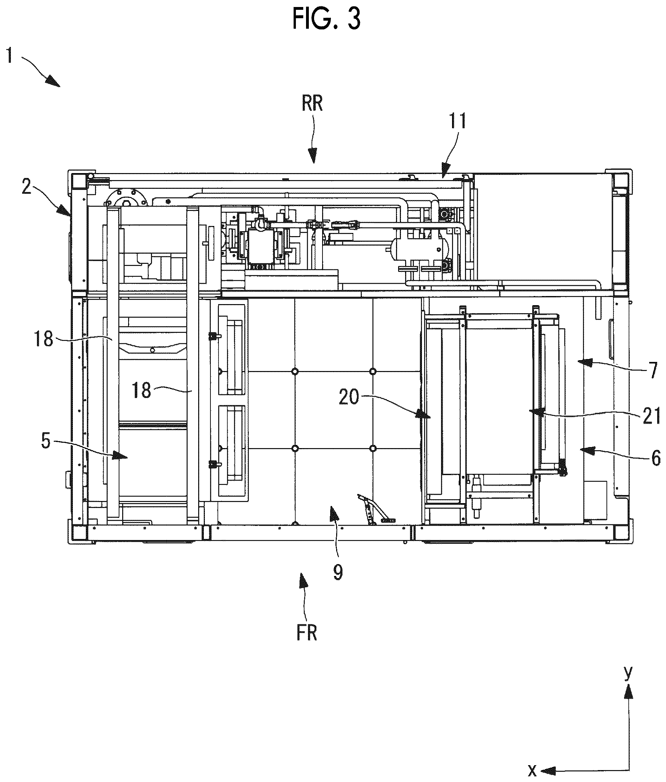

FIG. 3 is a plan view of the container-type data center 1 described above. As can be seen from FIG. 3, for example, the immersion vessel 5 is provided on the left side, the air cooling rack 6 and the water cooling rack 7 are provided on the right side, and the work space 9 is provided in the center of these when viewed from the front surface FR. For example, the machine room 11 is provided on the rear surface RR side.

A ceiling rail 18 is provided above the immersion vessel 5. The server (electronic device) is transported by a crane traveling on the ceiling rail 18.

A water heat exchanger (air cooling heat exchanger) 20 for cooling and an indoor unit 21 of an air conditioner are provided above the air cooling rack 6 and the water cooling rack 7.

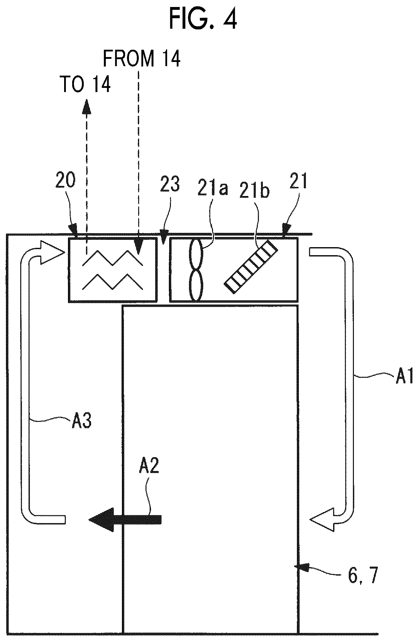

As shown in FIG. 4, the water heat exchanger 20 for air cooling and the indoor unit 21 are disposed in a cooling flow path 23 through which cooling air flows. The cooling water is guided from the radiator 14 (refer to FIG. 2) to the water heat exchanger 20 for air cooling, and the cooling water after cooling the cooling air is returned to the radiator 14. The indoor unit 21 is provided with an indoor unit fan 21a and an evaporator (air cooling evaporator) 21b.

The refrigerant after being decompressed by an expansion valve is guided to the evaporator 21b from the outdoor unit 15 (refer to FIG. 2), and the refrigerant after evaporation is guided to a condenser of the outdoor unit 15. The outdoor unit 15 is provided with a compressor that compresses the refrigerant, the expansion valve that expands the compressed refrigerant, and the condenser that condenses the evaporated refrigerant. Accordingly, the indoor unit 21 and the outdoor unit 15 constitute an air conditioner (vapor compression type cooling device).

The cooling air is guided to the air cooling rack 6 and the water cooling rack 7 as indicated by an arrow A1 after passing through the water heat exchanger 20 for air cooling and the indoor unit 21, and flows out as indicated by an arrow A2 after cooling the servers of the air cooling rack 6 and the water cooling rack 7. The cooling air that has flowed out is guided again to the water heat exchanger 20 for air cooling and the indoor unit 21 as indicated by an arrow A3, and is circulated.

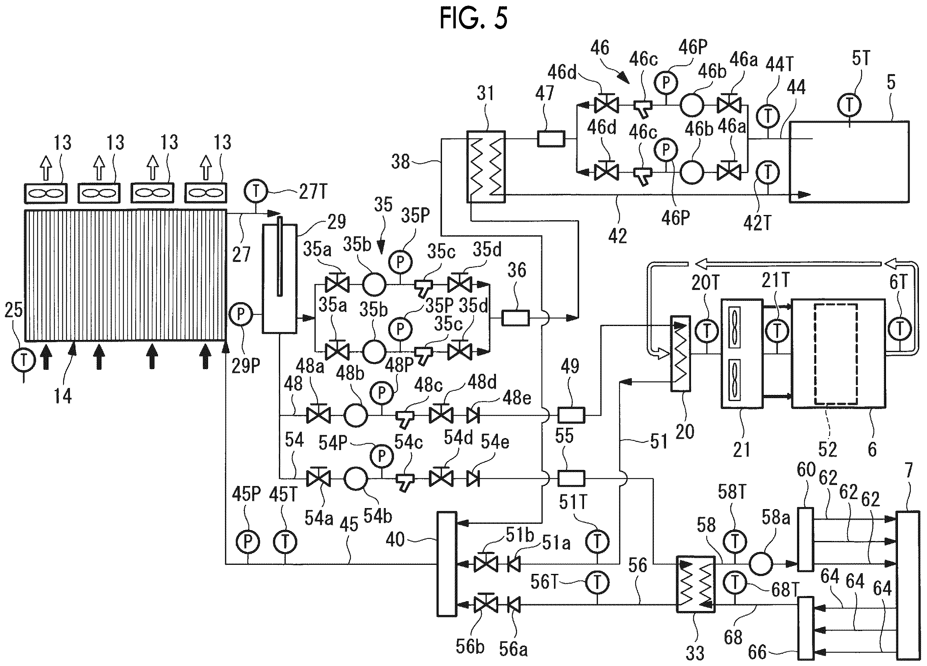

FIG. 5 shows a cooling circuit in which immersion cooling using the immersion vessel 5 described above, air cooling using the air cooling rack 6, and water cooling using the water cooling rack 7 are performed.

The radiator 14 is, for example, a fin-tube type heat exchanger, and heat is exchanged between air (outside air) flowing outside and cooling water flowing inside the tube. The air guided to the radiator 14 is drawn by the air cooling fan 13. Control such as start and stop of the radiator 14 is performed by a control unit (not shown).

An outside air temperature sensor 25 that measures a temperature of outside air is provided in the vicinity of the radiator 14. Output of the outside air temperature sensor 25 is transmitted to the control unit.

The cooling water cooled by the radiator 14 is guided to a cooling water tank 29 through a cooling water outlet pipe 27 and is temporarily stored. A temperature sensor 27T is provided in the cooling water outlet pipe 27, and an output value thereof is transmitted to the control unit. A pressure sensor 29P is provided in the cooling water tank 29, and an output value thereof is transmitted to the control unit.

The cooling water is guided from the cooling water tank 29 to a water heat exchanger 31 for immersion, the water heat exchanger 20 for air cooling, and a water heat exchanger 33 for water cooling.

A water supply unit 35 and a flow meter 36 are provided between the cooling water tank 29 and the water heat exchanger 31 for immersion. Two systems of the water supply unit 35 are provided in parallel, and an automatic on-off valve 35a, a water pump 35b, a pressure sensor 35P, a strainer 35c, and a manual on-off valve 35d are provided in order from an upstream side of the cooling water flow. The automatic on-off valve 35a operates according to a command from the control unit. The output of the pressure sensor 35P and the output of the flow meter 36 are transmitted to the control unit.

Each system of the water supply unit 35 is switched by operating the automatic on-off valve 35a according to the command from the control unit. That is, redundancy is provided by using one system and employing the other system as a backup.

The cooling water guided to the water heat exchanger 31 for immersion through the flow meter 36 undergoes heat exchange in the water heat exchanger 31 for immersion, and after that, is guided through a return pipe 38 to a cooling water return tank 40 and is temporarily stored therein.

The cooling water stored in the cooling water return tank 40 is returned to the radiator 14 through the cooling water return pipe 45. The cooling water return pipe 45 is provided with a temperature sensor 45T and a pressure sensor 45P, and the output of the temperature sensor 45T and the output of the pressure sensor 45P are transmitted to the control unit.

In the water heat exchanger 31 for immersion, the cooling water and the cooling liquid guided to the immersion vessel 5 exchange heat with each other. The cooling liquid cooled by the cooling water in the water heat exchanger 31 for immersion is guided to the immersion vessel 5 through a cooling liquid supply pipe 42. A temperature sensor 42T is provided in the cooling liquid supply pipe 42, and the output of the temperature sensor 42T is transmitted to the control unit. The immersion vessel 5 is provided with a temperature sensor 5T that measures a temperature of the cooling liquid, and the output of the temperature sensor 5T is transmitted to the control unit.

A cooling liquid return pipe 44 that returns the cooling liquid to the water heat exchanger 31 for immersion is connected to the immersion vessel 5. A temperature sensor 44T is provided in the cooling liquid return pipe 44, and the output of the temperature sensor 44T is transmitted to the control unit.

The cooling liquid return pipe 44 is provided with a cooling liquid return unit 46 and a flow meter 47. Two systems of the cooling liquid return unit 46 are provided in parallel, and an automatic on-off valve 46a, a water pump 46b, a pressure sensor 46P, a strainer 46c, and a manual on-off valve 46d are provided in order from an upstream side of the cooling liquid flow. The automatic on-off valve 46a operates according to a command from the control unit. The output of the pressure sensor 46P and the output of the flow meter 47 are transmitted to the control unit.

Each system of the cooling liquid return unit 46 is switched by operating the automatic on-off valve 46a according to the command from the control unit. That is, redundancy is provided by using one system and employing the other system as a backup.

A cooling water supply pipe 48 for air cooling is provided between the cooling water tank 29 and the water heat exchanger 20 for air cooling, and an automatic on-off valve 48a, a water pump 48b, a pressure sensor 48P, a strainer 48c, a manual on-off valve 48d, a check valve 48e, and a flow meter 49 are provided in order from the upstream side of the cooling water flow. The automatic on-off valve 48a operates according to a command from the control unit. The output of the pressure sensor 48P and the output of the flow meter 49 are transmitted to the control unit.

The cooling water guided to the water heat exchanger 20 for air cooling through the flow meter 49 undergoes heat exchange in the water heat exchanger 20 for air cooling, and after that, is guided to the cooling water return tank 40 through a return pipe 51 and is temporarily stored therein. The return pipe 51 is provided with a temperature sensor 51T, a check valve 51a, and an automatic on-off valve 51b. Output of the temperature sensor 51T is transmitted to the control unit.

As described with reference to FIG. 4, the indoor unit 21 is provided on a downstream side of the cooling air flow of the water heat exchanger 20 for air cooling. The cooling air flowing out from the indoor unit 21 flows through the air cooling rack 6 on which a server 52 is mounted, and is returned to the water heat exchanger 20 for air cooling again.

Temperature sensors 20T, 21T, and 6T are provided on a downstream side of the water heat exchanger 20 for air cooling, a downstream side of the indoor unit 21, and a downstream side of the air cooling rack 6, respectively, and each output of the temperature sensors is transmitted to the control unit.

A cooling water supply pipe 54 for water cooling is provided between the cooling water tank 29 and the water heat exchanger 33 for water cooling, and an automatic on-off valve 54a, a water pump 54b, a pressure sensor 54P, a strainer 54c, a manual on-off valve 54d, a check valve 54e, and a flow meter 55 are provided in order from the upstream side of the cooling water flow. The automatic on-off valve 54a operates according to a command from the control unit. The output of the pressure sensor 54P and the output of the flow meter 55 are transmitted to the control unit.

The cooling water guided to the water heat exchanger 33 for water cooling through the flow meter 55 undergoes heat exchange in the water heat exchanger 33 for water cooling, and after that, is guided to the cooling water return tank 40 through a return pipe 56 and is temporarily stored therein. The return pipe 56 is provided with a temperature sensor 56T, a check valve 56a, and an automatic on-off valve 56b. Output of the temperature sensor 56T is transmitted to the control unit.

In the water heat exchanger 33 for water cooling, the cooling water and a heat sink coolant guided to the water-cooled heat sink of the water cooling rack 7 exchange heat with each other. The heat sink coolant cooled by the water heat exchanger 33 for water cooling is guided to an inlet header 60 through a coolant supply pipe 58. The coolant supply pipe 58 is provided with a temperature sensor 58T and a coolant pump 58a. Output of the temperature sensor 58T is transmitted to the control unit.

The coolant in the inlet header 60 is guided to respective water-cooled heat sinks of the water cooling rack 7 through a plurality of supply flow paths 62. In the water-cooled heat sinks, electronic components such as CPUs are water-cooled. The coolant that has cooled electronic components in the water-cooled heat sink is guided to an outlet header 66 through a return flow path 64. The coolant stored in the outlet header 66 is guided to the water heat exchanger 33 for water cooling again through a coolant return pipe 68. The coolant return pipe 68 is provided with a temperature sensor 68T, and the output of the temperature sensor 68T is transmitted to the control unit.

The control unit includes, for example, a central processing unit (CPU), a random-access memory (RAM), a read-only memory (ROM), a computer-readable storage medium, and the like. A series of pieces of processing for achieving various functions is stored in, for example, a storage medium or the like in a program format, and the CPU reads out the program to the RAM or the like, and executes processing for information processing and calculation to achieve various functions. The program may adopt a form in which the program is installed in advance in the ROM or another storage medium, a form in which the program is provided in a stored state in the computer-readable storage medium, a form in which the program is distributed via wired or wireless communication means, or the like. The computer-readable storage medium is a magnetic disk, a magneto-optical disk, a CD-ROM, a DVD-ROM, a semiconductor memory, or the like.

The container-type data center 1 of the above-described embodiment is used as follows.

Since the immersion vessel 5 is provided inside the container body 2, the server can be immersion-cooled. Further, since the air cooling rack 6 is provided, the server can be air-cooled. Further, since the water cooling rack 7 is provided, the server can be water-cooled. The user can select three cooling methods according to the amount of heat generated by a server to be used. As the selection of the cooling method, any one may be selected, or two or all of the cooling methods may be selected. When the cooling method is performed, the automatic on-off valves 35a, 48a, 54a, and 46a are appropriately controlled to be opened and closed by the control unit. All of the manual on-off valves 35d, 48d, 54d, and 46d are opened when the container-type data center 1 is used. For example, in a case where only immersion cooling is selected, the automatic on-off valves 35a and 46a are opened, and the automatic on-off valves 48a and 54a are closed.

In a case where the air cooling rack 6 is used, the water heat exchanger 20 for air cooling and the indoor unit 21 are controlled as follows.

In a case where a temperature outside the container body 2 (output value of the outside air temperature sensor 25) is equal to or lower than a predetermined value, the operation of the indoor unit 21 is stopped by using the water heat exchanger 20 for air cooling. That is, the operation of the air conditioner is stopped, and an operation with reduced power of the air conditioner is performed.

In a case where the temperature outside the container body 2 exceeds the predetermined value, the operation of the water heat exchanger 20 for air cooling is stopped, and the indoor unit 21 is operated to cool the cooling air to a desired value by the air conditioner.

Actions and effects of the present embodiment described above are as follows.

The immersion vessel 5 for performing immersion cooling, the air cooling rack 6, and the water cooling rack 7 are provided inside the container body 2. Accordingly, in one container-type data center 1, it is possible to select a cooling method according to the amount of heat generated by electronic devices such as servers.

The cooling air guided to the air cooling rack 6 is cooled by the evaporator 21b of the air conditioner and the water heat exchanger 20 for air cooling. Then, by controlling the operation of the evaporator 21b of the air conditioner and the water heat exchanger 20 for air cooling, it is possible to appropriately perform cooling according to the amount of heat generated by the electronic devices provided in the air cooling rack 6.

In a case where the temperature outside the container body 2 is equal to or lower than the predetermined value, the cooling water can be cooled to a desired temperature by the radiator 14. Therefore, cooling using the water heat exchanger 20 for air cooling is performed. In this case, the load on the evaporator 21b can be reduced or the operation thereof can be stopped. Therefore, the power of the air conditioner can be reduced.

In a case where the temperature outside the container body 2 exceeds the predetermined value, cooling by the water heat exchanger 20 for air cooling cannot be expected. Therefore, it is possible to reduce power consumption by stopping the operation of the water heat exchanger 20 for air cooling.

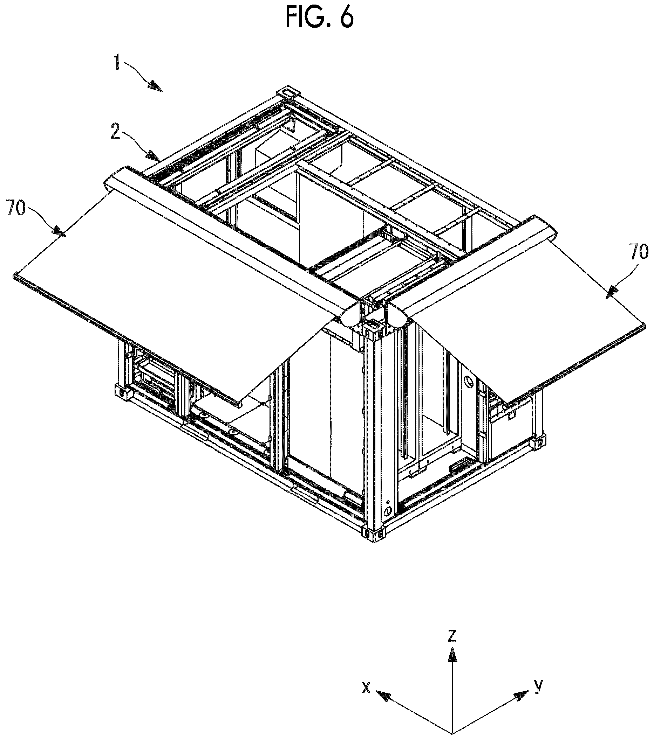

As shown in FIG. 6, a roof 70 that can extend outward from an upper portion of the container body 2 may be provided.

By providing the roof 70, it is possible to avoid rain and sunshine under the roof. Accordingly, it is possible to facilitate work such as loading into and unloading from the container-type data center 1.

It is preferable that the roof 70 extends outward of the container body 2 only when work such as loading and unloading is performed, and is accommodated at other times so as not to impair the outer shape of the container body. For example, a tarp capable of stretching out a cloth at the time of use can be used.

The container-type data center and the control method therefor described in each of the embodiments described above are understood as follows, for example.

A container-type data center (1) according to a first aspect of the present disclosure includes a container body (2), an immersion vessel (5) that is provided inside the container body and in which a cooling liquid for immersing and cooling an electronic device is stored, an air cooling rack (6) that is provided inside the container body and through which cooling air passes, and a water cooling rack (7) that is provided inside the container body and includes a water-cooled heat sink that is attached to a heat generating portion of the electronic device while being brought into contact with the heat generating portion.

The immersion vessel for performing immersion cooling, the air cooling rack, and the water cooling rack are provided inside the container body. Accordingly, in one container-type data center, it is possible to select a cooling method according to the amount of heat generated by electronic devices such as servers.

In the container-type data center according to a second aspect of the present disclosure, in the first aspect, the container-type data center includes a vapor compression type cooling device including a compressor that compresses a refrigerant, an expansion valve that expands the compressed refrigerant, an air cooling evaporator (21b) that evaporates the expanded refrigerant and cools air, and a condenser that condenses the evaporated refrigerant, a cooling water type cooling device including a radiator (14) that discharges sensible heat of cooling water to an outside of the container body to cool the cooling water, and an air cooling heat exchanger (20) that cools air with the cooling water cooled by the radiator, a cooling flow path (23) in which the air cooling evaporator and the air cooling heat exchanger are disposed and through which cooling air guided to the air cooling rack flows, and a control unit that controls operations of the air cooling evaporator and the air cooling heat exchanger.

The cooling air guided to the air cooling rack is cooled by the air cooling evaporator of the vapor compression type cooling device and the air cooling heat exchanger of the cooling water type cooling device. Then, by controlling the operation of the air cooling evaporator and the air cooling heat exchanger, it is possible to appropriately perform cooling according to the amount of heat generated by the electronic devices provided in the air cooling rack.

In the container-type data center according to a third aspect of the present disclosure, in the second aspect, the control unit operates the air cooling heat exchanger to cool the cooling air guided to the air cooling rack in a case where a temperature outside the container body is equal to or lower than a predetermined value.

In a case where the temperature outside (for example, outside air temperature) the container body is equal to or lower than the predetermined value, the cooling water can be cooled to a desired temperature by the radiator. Therefore, cooling using the air cooling heat exchanger is performed. In this case, the load on the air cooling evaporator can be reduced or the operation thereof can be stopped. Therefore, the power of the vapor compression type cooling device can be reduced.

In a case where the temperature outside the container body exceeds the predetermined value, cooling by the air cooling heat exchanger cannot be expected. Therefore, it is preferable to stop the operation of the air cooling heat exchanger.

In the container-type data center according to a fourth aspect of the present disclosure, in any one of the first aspect to the third aspect, the container-type data center further includes a roof (70) that is capable of extending outward from an upper portion of the container body.

By providing the roof that is capable of extending outward from the upper portion of the container body, it is possible to avoid rain or sunshine under the roof. Accordingly, it is possible to facilitate work such as loading into and unloading from the container-type data center.

It is preferable that the roof extends outward of the container body only when work such as loading and unloading is performed, and is accommodated at other times so as not to impair the outer shape of the container body. For example, a tarp capable of stretching out a cloth at the time of use can be used.

A control method for a container-type data center according to a first aspect of the present disclosure, the container-type data center including a container body, an immersion vessel that is provided inside the container body and in which a cooling liquid for immersing and cooling an electronic device is stored, an air cooling rack that is provided inside the container body and through which cooling air passes, a water cooling rack that is provided inside the container body and includes a water-cooled heat sink that is attached to a heat generating portion of the electronic device while being brought into contact with the heat generating portion, a vapor compression type cooling device including a compressor that compresses a refrigerant, an expansion valve that expands the compressed refrigerant, an air cooling evaporator that evaporates the expanded refrigerant and cools air, and a condenser that condenses the evaporated refrigerant, a cooling water type cooling device including a radiator that discharges sensible heat of cooling water to an outside of the container body to cool the cooling water, and an air cooling heat exchanger that cools air with the cooling water cooled by the radiator, and a cooling flow path in which the air cooling evaporator and the air cooling heat exchanger are disposed and through which cooling air guided to the air cooling rack flows, the control method further includes operating the air cooling heat exchanger to cool the cooling air guided to the air cooling rack in a case where a temperature outside the container body is equal to or lower than a predetermined value.

### Reference Signs List

1: container-type data center
2: container body
4: frame member
5: immersion vessel
6: air cooling rack
7: water cooling rack
8: distribution board
9: work space
11: machine room
13: air cooling fan
14: radiator
15: outdoor unit
18: ceiling rail
20: water heat exchanger for cooling (air cooling heat exchanger)
21: indoor unit
21a: indoor unit fan
21b: evaporator (air cooling evaporator)
25: outside air temperature sensor
27: cooling water outlet pipe
27T: temperature sensor
29: cooling water tank
29P: pressure sensor
31: water heat exchanger for immersion
33: water heat exchanger for water cooling
35: water supply unit
35a: automatic on-off valve
35b: water pump
35c: strainer
35d: manual on-off valve
35P: pressure sensor
36: flow meter
38: return pipe
40: cooling water return tank
42: cooling liquid supply pipe
44: cooling liquid return pipe
45: cooling water return pipe
45T: temperature sensor
45P: pressure sensor
46: cooling liquid return unit
46a: automatic on-off valve
46b: water pump
46c: strainer
46d: manual on-off valve
46P: pressure sensor
47: flow meter
48: cooling water supply pipe for air cooling
48a: automatic on-off valve
48b: water pump
48c: strainer
48d: manual on-off valve
48e: check valve
48P: pressure sensor
49: flow meter
51: return pipe
51a: check valve
51b: automatic on-off valve
51T: temperature sensor
52: server
54: cooling water supply pipe for water cooling
54a: automatic on-off valve
54b: water pump
54c: strainer
54d: manual on-off valve
54e: check valve
54P: pressure sensor
55: flow meter
56: return pipe
56a: check valve
56b: automatic on-off valve
56T: temperature sensor
58: coolant supply pipe
58a: coolant pump
58T: temperature sensor
60: inlet header
62: supply flow path
64: return flow path
66: outlet header
68: coolant return pipe
68T: temperature sensor
70: roof

## Claims

1. A container-type data center comprising:
a container body;
an immersion vessel that is provided inside the container body and in which a cooling liquid for immersing and cooling an electronic device is stored;
an air cooling rack that is provided inside the container body and through which cooling air passes; and
a water cooling rack that is provided inside the container body and includes a water-cooled heat sink that is attached to a heat generating portion of the electronic device while being brought into contact with the heat generating portion.

2. The container-type data center according to Claim 1, further comprising:
a vapor compression type cooling device including a compressor that compresses a refrigerant, an expansion valve that expands the compressed refrigerant, an air cooling evaporator that evaporates the expanded refrigerant and cools air, and a condenser that condenses the evaporated refrigerant;
a cooling water type cooling device including a radiator that discharges sensible heat of cooling water to an outside of the container body to cool the cooling water, and an air cooling heat exchanger that cools air with the cooling water cooled by the radiator;
a cooling flow path in which the air cooling evaporator and the air cooling heat exchanger are disposed and through which cooling air guided to the air cooling rack flows; and
a control unit that controls operations of the air cooling evaporator and the air cooling heat exchanger.

3. The container-type data center according to Claim 2, wherein the control unit operates the air cooling heat exchanger to cool the cooling air guided to the air cooling rack in a case where a temperature outside the container body is equal to or lower than a predetermined value.

4. The container-type data center according to Claim 1, further comprising:
a roof that is capable of extending outward from an upper portion of the container body.

5. A control method for a container-type data center, the container-type data center including
a container body,
an immersion vessel that is provided inside the container body and in which a cooling liquid for immersing and cooling an electronic device is stored,
an air cooling rack that is provided inside the container body and through which cooling air passes,
a water cooling rack that is provided inside the container body and includes a water-cooled heat sink that is attached to a heat generating portion of the electronic device while being brought into contact with the heat generating portion,
a vapor compression type cooling device including a compressor that compresses a refrigerant, an expansion valve that expands the compressed refrigerant, an air cooling evaporator that evaporates the expanded refrigerant and cools air, and a condenser that condenses the evaporated refrigerant,
a cooling water type cooling device including a radiator that discharges sensible heat of cooling water to an outside of the container body to cool the cooling water, and an air cooling heat exchanger that cools air with the cooling water cooled by the radiator, and
a cooling flow path in which the air cooling evaporator and the air cooling heat exchanger are disposed and through which cooling air guided to the air cooling rack flows, the control method comprising:
operating the air cooling heat exchanger to cool the cooling air guided to the air cooling rack in a case where a temperature outside the container body is equal to or lower than a predetermined value.
